# EUROPEAN PATENT APPLICATION

(11) **EP 1 511 067 A2**
(43) Date of publication of application: **02.03.2005**
(21) Application number: 04254850.3
(22) Date of filing: 12.08.2004
(51) Int. Cl.: H01J 37/32

(54) **Etching method for semiconductor device**

(30) Priority: 12.08.2003 JP 2003207352
(71) Applicant: Masuoka, Fujio, Sendai-shi, Miyagi 981-0923 (JP); Sharp Kabushiki Kaisha, Osaka-shi, Osaka 545-8522 (JP)
(72) Inventor: Masuoka, Fujio, Sendai-shi Miyagi 981-0923 (JP); Horii, Shinji, Fukuyama-shi Hiroshima 721-0902 (JP); Tanigami, Takuji, Fukuyama-shi Hiroshima 720-0082 (JP); Yokoyama, Takashi, Fukuyama-shi Hiroshima 721-0902 (JP)
(74) Representative: Brown, Kenneth Richard

(57) **Abstract**

An etching method for a semiconductor device comprising the steps of: generating an etching species atmosphere above the semiconductor device having a step composed of a main surface and a sidewall; and applying an electric field to accelerate the etching species in one direction and a magnetic field along a plane that crosses the one direction at a specific angle so that the sidewall is etched.

## Description

### BACKGROUND OF THE INVENTION

### Field of the Invention

The present invention relates to an etching method for a semiconductor device. In particular, the present invention relates to a method for etching a sidewall of a step, which is composed of a main surface and the sidewall, of a semiconductor device.

### Description of the Background Art

It is necessary to form a plurality of microscopic semiconductor devices on a semiconductor substrate for the manufacture of a large scale semiconductor integrated circuit. In order for this to be achieved, a so-called planer technology is well used for collectively forming semiconductor devices planarly on a surface of a semiconductor substrate. According to this technology, a reactive ion etching (RIE) technique is conventionally used for the manufacture of semiconductor devices in accordance with a manufacturing method that includes anisotropic etching.

According to such reactive ion etching, etching is carried out as follows. An etching gas is ionized using plasma, and ion species are allowed to collide with the surface of semiconductor devices to be processed using the potential difference between the plasma potential and the potential of the semiconductor devices. This ion impact activates the material that exists in the portions to be etched. The activated material is etched prior to others to be removed. This method is referred to as anisotropic etching because the ion species have directivity, causing the bottom of the semiconductor devices to be etched before the sidewalls.

Reactive ion etching allows ion species to collide with the surface of semiconductors in the normal direction relative to the surface of semiconductor substrate, enabling anisotropic etching to be carried out in the depth direction of the semiconductor substrate. It is difficult, however, for the reactive ion etching to carry out anisotropic etching in the horizontal direction relative to the surface of the semiconductor substrate.

Another reason for this is because it is difficult to provide an opening in masks only in the vertical direction relative to the surface of the semiconductor substrates.

As described above, according to the planer technology wherein the semiconductor devices such as transistors are formed planarly on the semiconductor substrate, it is difficult to carry out etching in the direction parallel to the surface of the semiconductor substrate. In recent years, it has been demanded that precise etching be carried out in the above-described parallel direction, as there increases the need for a reduction in processing dimensions and higher integration density of semiconductor devices.

A non-volatile memory such as a flash EEPROM is used as a compact data recording medium with a large capacity in various fields such as computers, telecommunications, measuring instruments, automatic controllers, and consumer electronic appliances. Accordingly, demand for a cheaper non-volatile memory with larger capacity is very high.

However, the size of memory cells (semiconductor devices) formed by the above-described planer technology is limited by the minimum processing dimensions (feature size) which are the resolution limit of the photolithographic technology. Under such conditions, a three-dimensional technology for memory cells has been developed as one technology that achieves a larger integration density than the miniaturization limit of the processing dimensions, without requiring any improvements in the photolithographic technology.

According to the three-dimensional technology for memory cells, memory cells are aligned in the direction vertical to the surface of a semiconductor substrate so that the number of memory cells can be increased, whereby an increase in storage capacity can be achieved. In the case where the memory cells are aligned and layered in the vertical direction as described above, it is required that etching of the sides of the memory cells, i.e. etching in the direction parallel to the surface of the semiconductor substrate, be precisely controlled.

According to any of the conventional reactive ion etching technologies, however, accelerated ions are implanted into the surface of a semiconductor substrate and therefore, it is difficult to etch in the horizontal direction relative to the surface of the semiconductor substrate (for example, Japanese Unexamined Patent Publication No. HEI 7(1995)-94467). Thus, it is also difficult to meet the demand for a larger integration density of semiconductor devices that exceeds the limit of miniaturization of the procession dimensions.

### SUMMARY OF THE INVENTION

The present invention has been created in order to solve the above described problems, by the inventors of the present invention who unexpectedly discovered that it is possible to etch a sidewall of a step, which is composed of a main surface and the sidewall, of a semiconductor device by controlling application directions of a magnetic field or magnetic and electric fields to etching species, and by utilizing reactions that occur between the etching species and the sidewall.

Thus, the present invention provides an etching method for a semiconductor device comprising: generating an etching species atmosphere above the semiconductor device having a step composed of a main surface and a sidewall; and applying an electric field to accelerate the etching species in one direction and a magnetic field along a plane that crosses the one direction at a specific angle so that the sidewall is etched.

Furthermore, the present invention provides an etching method for a semiconductor device comprising the steps of: generating an etching species atmosphere above the semiconductor device having a step composed of a main surface and a sidewall; and applying an electric field along a plane that crosses the main surface at a specific angle so that the etching species are accelerated to etch the sidewall.

In addition, the present invention provides an etching method for a semiconductor device comprising the steps of: generating an etching species atmosphere above the semiconductor device having a step composed of a main surface and a sidewall; and heating the etching species and a material forming the sidewall to a predetermined temperature at which the etching species and the material react with each other to etch the sidewall.

These and other objects of the present application will become more readily apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

Figs. 1a and 1b are schematic diagrams showing an etching method according to one embodiment of the present invention;
Figs. 2a and 2b are schematic diagrams showing an etching method according to one embodiment of the present invention;
Figs. 3a and 3b are schematic diagrams showing an etching method according to one embodiment of the present invention;
Figs. 4a and 4b are schematic diagrams showing an etching method according to one embodiment of the present invention;
Figs. 5a and 5b are schematic diagrams showing an etching method according to one embodiment of the present invention;
Figs. 6a and 6b are schematic diagrams showing an etching method according to one embodiment of the present invention;
Figs. 7a and 7b are schematic diagrams showing an etching method according to one embodiment of the present invention;
Fig. 8 is a schematic diagram showing an etching method according to one embodiment of the present invention;
Fig. 9 is a schematic diagram showing an etching method according to one embodiment of the present invention;
Figs. 10a and 10b are schematic diagrams showing an etching method according to one embodiment of the present invention;
Figs. 11a and 11b are schematic diagrams showing an etching method according to one embodiment of the present invention;

### DETAILED DESCRIPTION OF THE PREFERRED EMBODIMENTS

A variety of semiconductor devices can be cited as the semiconductor device that can be utilized in the etching method of the present invention without any particular limitations, as long as the semiconductor device has a step composed of a main surface and a sidewall. A variety of semiconductor devices having a semiconductor layer such as a non-volatile memory, a semiconductor laser and a solar cell can be mentioned. Furthermore, the semiconductor device used in the present invention may include one that is in course of manufacture. A member that constitutes the semiconductor device of the present invention may be used any members that constitute known semiconductor devices such as a semiconductor substrate or, a semiconductor layer, an electrode and an insulating film formed on the semiconductor substrate.

A material that forms the step which is etched is not particularly limited as long as the material can be etched. More specifically, semiconductor layer materials such as silicon, germanium, silicon germanium, gallium arsenide and indium phosphide, electrode materials such as aluminum, copper polysilicon and silicide, and insulating film materials such as silicon oxide and silicon nitride can be used.

The shape of the step, which is composed of the main surface and the sidewall, is not particularly limited. The angle of the sidewall relative to the main surface may be any angle from 0° to 180° exclusive. In particular, for achieving the effect of the present invention, that is, for etching the sidewall prior to other surfaces, the angle is preferably in the range of 45° to 135°.

In addition, the number of steps is not particularly limited and the semiconductor device can have a desired number of steps as long as it has one or more steps. For Example, the semiconductor device may be provided with a plurality of protrusions in the form of stripes or dots, and surfaces of each protrusion may constitute the steps. When the protrusions in stripe form are seen in cross section perpendicular to the longitudinal direction thereof, two sidewalls of each protrusion are subjected to etching according to the present invention. When the protrusions are in dot form, the entire surface of the sidewall is subjected to etching according to the present invention. Here, these two examples are mere illustrations, and the number and form of the steps can be appropriately changed in accordance with the constitution of the semiconductor device to be manufactured.

The etching species utilized for the etching are appropriately selected in accordance with the type of material that forms the sidewall of the step. Examples of the etching species will be described later in the specification.

The following three types of methods can be mentioned as the method for etching the step according to the present invention.
(1) An etching method in which an electric field is applied to the etching species so that the etching species are accelerated in one direction and a magnetic field is applied along a plane that crosses this direction at a specific angle (ex. from 0° to 180°).
(2) An etching method in which an etching species atmosphere is generated and an electric field is then applied along a plane that crosses the main surface at a specific angle (ex. from 0° to 180°) so that the etching species are accelerated to etch the sidewall.
(3) An etching method in which an etching species atmosphere is generated and the etching species and a material forming the sidewall are then heated to a predetermined temperature to etch the sidewall.

According to method (1), the incident direction of the etching species generally entered straight is bent in a desired direction by applying the magnetic field so that the etching species reach the sidewall, and as a result, the sidewall can be etched. In addition, the incident direction of the etching species and the application direction of the magnetic field can be combined freely without any particular limitation as long as the etching species can reach the sidewall.

In addition to the above, the following combinations can be mentioned. For example, the incident direction of the etching species which is made vertical to the main surface can be combined with the application direction of the magnetic field which is rotated and made parallel to the main surface. Alternatively, the application direction of the magnetic field, which is made vertical to the main surface, can be combined with the incident direction of the etching species which is made to cross the main surface at a predetermined angle. Any of these combinations satisfies the conditions for making the etching species enter with the sidewall while being moved in a spiral motion.

Here, according to method (1), one direction indicates a direction that forms an arbitrary angle vis-à-vis the main surface of semiconductor device.

Next, according to method (2), the electric field is applied to the sidewall which has been exposed to the etching species atmosphere in advance and thereby, the etching species reach the sidewall and as a result, the sidewall is etched. According to this method, the application direction of the electric field may be in one direction, or may be rotated holding a predetermined angle relative to the main surface.

Furthermore, according to method (3), the sidewalls which have been exposed to the etching species atmosphere in advance are heated to a temperature at which the etching species and the material that forms the sidewalls react with each other, and in effect, the sidewall is etched. The heating temperature is appropriately set in accordance with the type of the etching species, and material that forms the sidewall.

The etching method of the present invention can be utilized to process a non-volatile memory to which a three-dimensional technology has been applied, trenches and via holes for forming element isolation regions and wires, and the like.

### EMBODIMENTS

Exemplary conditions of the etching method of the present invention are further described in reference to the following embodiments. The following embodiments are examples of the etching method of the present invention, and the present invention is not limited to these embodiments.

### Embodiment 1

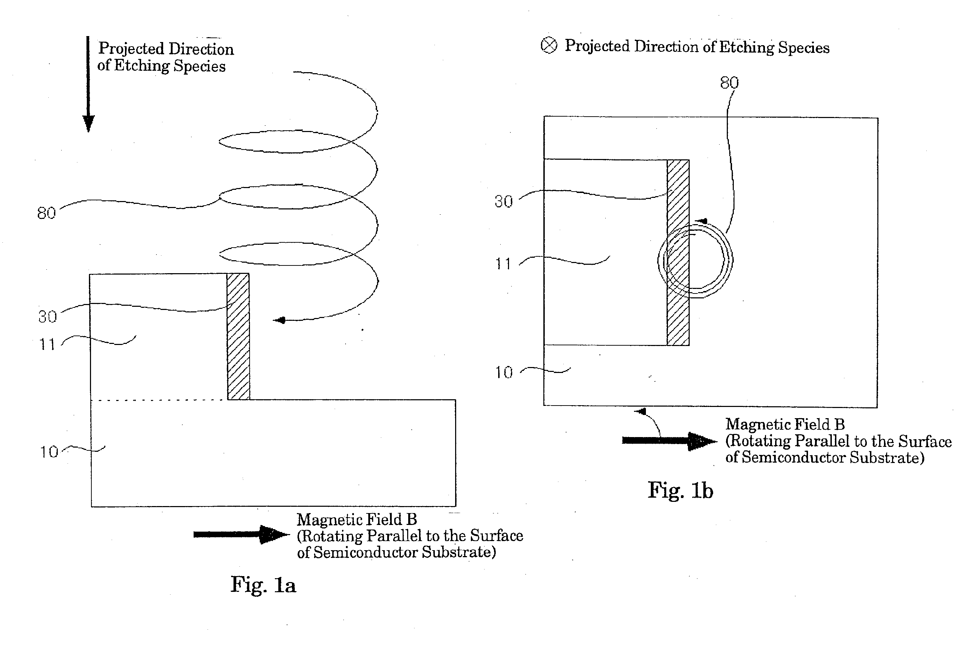

Figs. 1a and 1b are schematic diagrams showing an etching method according to one embodiment of the present invention. Fig. 1a is a cross sectional view, and Fig. 1b is a plan view seen from the direction in which the etching species are projected, as shown in Fig. 1a. Though the present embodiment shows a case of a P-type semiconductor substrate, the present embodiment can be applied to a case of an N-type semiconductor substrate.

In the present embodiment, a P-type silicon substrate 10 is utilized as an example of the P-type semiconductor substrate. In addition, the etching method of the present invention is applied to a semiconductor device, in which a semiconductor layer 11 having a step is formed on a silicon substrate 10. Etching species 80 that have been accelerated by means of an electric field of approximately 0.1 V to 1 MV, for example, ions that have been converted to plasma are implanted into the silicon substrate 10 in the direction normal to the surface of the silicon substrate.

A magnetic field B, having a magnetic flux density of approximately 1 nT to 100 T, for example, is applied to the etching species 80 in the direction horizontal to the surface of the silicon substrate. Lorentz force is applied to the etching species 80 by means of this magnetic field B and thereby, etching species 80 have kinetic energy in the direction horizontal to the surface of the silicon substrate. Furthermore, the magnetic field B that has been applied in the direction horizontal to the surface of the silicon substrate is rotated within a plane horizontal to the surface of the silicon substrate at, for example, a speed of 1 to 1000 rotations per minute. As a result of the rotation, the etching species move in a spiral motion in planes horizontal to the surface of the silicon substrate. That is to say, the etching species reach the sidewalls of the semiconductor layer 11 while forming a spiral relative to the surface of the silicon substrate.

Here, the magnetic flux density of magnetic field B that is applied in the direction horizontal to the surface of the silicon substrate and the speed of rotation of the magnetic field B in the plane horizontal to the surface of the silicon substrate are preferably 1 nT to 100 T and 1 to 1000 rotations per minute, respectively. However, the ranges of the numbers are not particularly limited as long as it remains possible to carry out etching in a desired manner.

The etching species 80 have kinetic energy in the direction horizontal to the surface of the silicon substrate according to the above described technique. As a result, the etching species 80 collide with the sidewall of the semiconductor layer 11 that extends in the direction normal to the surface of the silicon substrate. This collision makes it possible to carry out anisotropic etching of the semiconductor layer in the direction horizontal to the surface of the silicon substrate. In the figures, a reference number 30 indicates a portion that is etched.

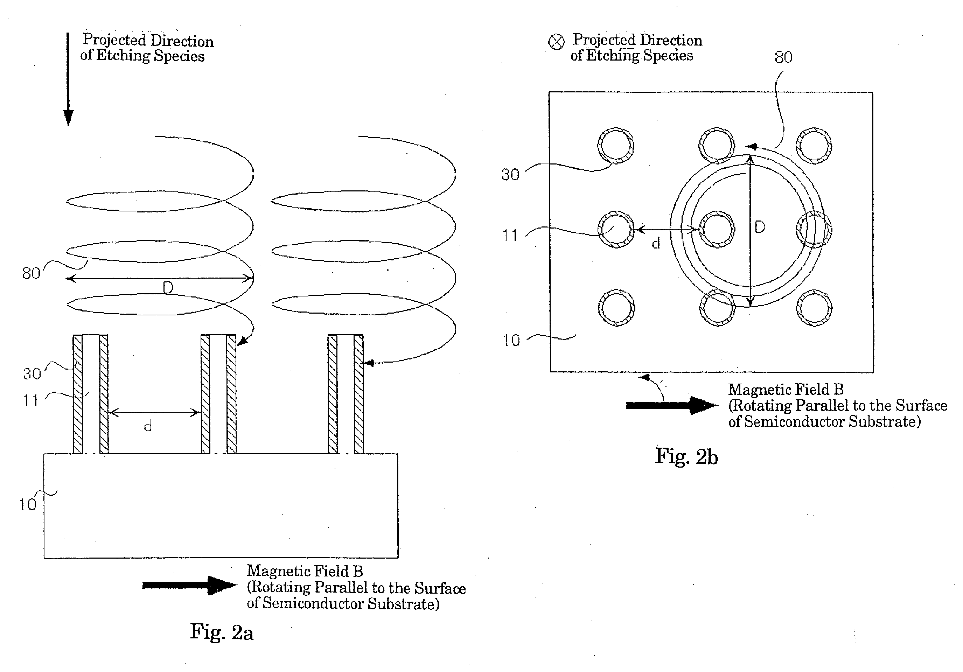

Furthermore, Figs. 2a and 2b show an example in which the etching method is applied to a semiconductor device which has at least two or more semiconductor layers 11, extending in the direction normal to the surface of the silicon substrate, on the silicon substrate 10. In this example, a magnetic field B is controlled so that the relationship d < D is maintained, where d indicates the distance between the above described semiconductor layers 11, and D indicates the diameter of the spiral motion of the etching species. As a result, the possibility of the etching species that have reached the surface of the silicon substrate 10 colliding with the sidewalls of the semiconductor layers 11 that extend in the direction normal to the surface of the silicon substrate is increased. Thus, it becomes possible to carry out more efficient etching of the semiconductor layer in the horizontal direction of the silicon substrate.

Though it is preferable for both distance d between semiconductor layers 11 and diameter D of the spiral motion to be in the range from 1 nm to 10 µm, they are not necessarily limited to this range.

Here, the above described Fig. 2a is a cross sectional view showing an etching method according to one embodiment of the present invention. Fig. 2b is a plan view seen from the direction in which the etching species are projected, as shown in Fig. 2a.

Here, it is desirable for the magnetic field B that is applied in the direction horizontal to the surface of the silicon substrate to be parallel to the surface of the silicon substrate. However, it is not necessary for the direction to be parallel as long as it is possible to carry out anisotropic etching, in the direction horizontal to the surface of the silicon substrate, on the sidewalls of the semiconductor layers 11 that extend in the direction normal to the surface of the silicon substrate.

In addition, in the case where the etched material (material that forms the sidewalls of the semiconductor layer 11) is silicon, Cl₂, HBr, CHF₃, or a mixed gas thereof can be used as the above described etching species 80. In the case where the etched material is a silicon oxide film, CF₄, C₅F₈, or a mixed gas thereof can be used as the above described etching species 80. In addition, in the case where the etched material is a silicon nitride film, CHF₃, C₄F₈, or a mixed gas thereof can be used as the above described etching species 80. The types of etched material and etching species are not particularly limited as long as etching is possible in the desired manner.

In addition, the etching method according to the present embodiment is not limited to etching for the semiconductor device using a silicon substrate, the etching method can be applied to semiconductors such as germanium, gallium arsenide, indium phosphide or the like.

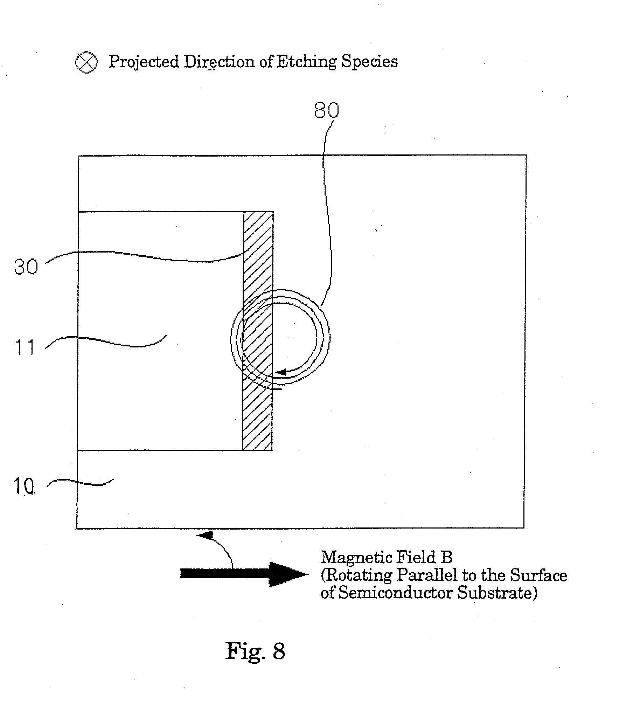

In addition, Fig. 1b and Fig. 2b show a case where the diameter D of the spiral motion of the etching species becomes greater as the etching species approach the silicon substrate 10. However, the present invention is not limited to this, and the above described diameter D may become smaller as the etching species approach the silicon substrate 10, as shown in Fig. 8, for example, or may not be changed. That is to say, a change in diameter D is not particularly limited before the etching species reach the silicon substrate and after the etching species have been projected as long as it is possible to carry out etching in a desired manner.

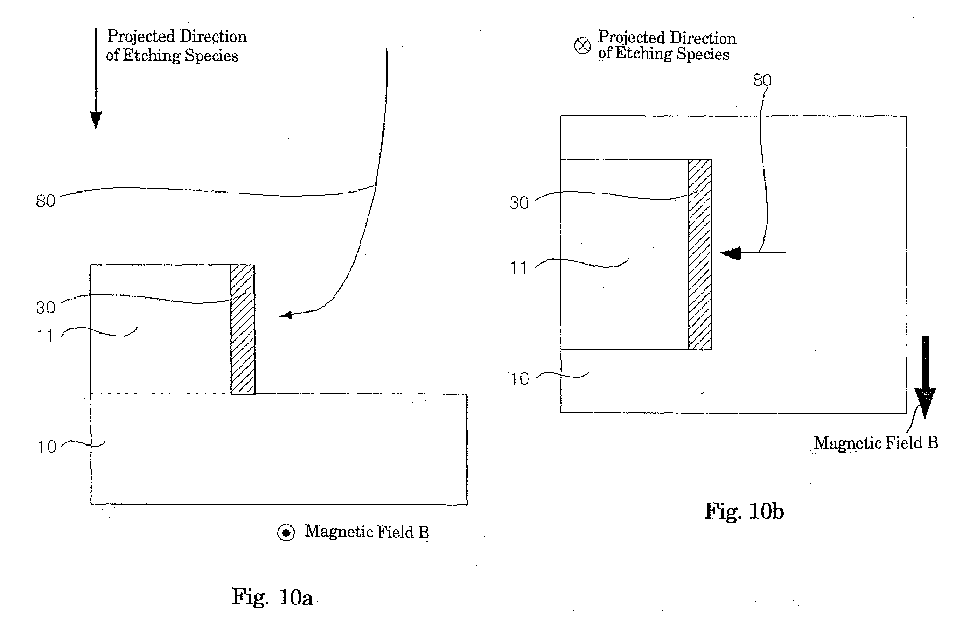

In addition, though the magnetic field B is rotated in the present embodiment, the silicon substrate 10 may be rotated instead. Furthermore, the direction of rotation may be either clockwise or anticlockwise. Moreover, as shown in Figs. 10a and 10b, the magnetic field B may not be rotated as long as it is possible to carry out etching in a desired manner.

Here, Fig. 10a is a cross sectional view showing an etching method according to one embodiment of the present invention. Fig. 10b is a plan view in the direction from which the etching species are projected as shown in Fig. 10a.

### Embodiment 2

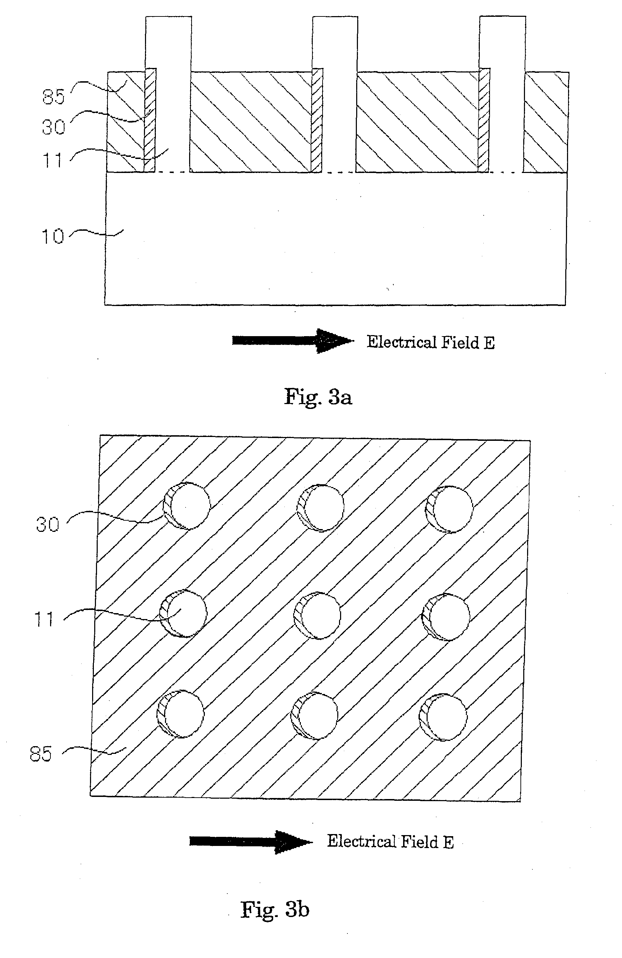

Figs. 3a and 3b are schematic diagrams showing an etching method according to one embodiment of the present invention. Fig. 3a is a cross sectional view and Fig. 3b is a plan view of Fig. 3a as seen from above. Here, though the present embodiment shows a case of a P-type semiconductor substrate, the present invention can also be applied in cases when an N-type semiconductor substrate is used.

In the present embodiment, a P-type silicon substrate 10, for example, is utilized as the P-type semiconductor substrate. In addition, the etching method according to the present invention is applied to the semiconductor device in which semiconductor layers 11 having steps are formed on the silicon substrate 10. An etching species atmosphere 85 is generated when the etching species, for example, ions that have been converted to plasma are transported into the vicinity of the surface of the silicon substrate 10 by means of an electric field of approximately 0.1 V to 1 kV, in the direction normal to the surface of the silicon substrate. An electric field E of 1 V to 1 MV, for example, is applied to the surface of the silicon substrate in the horizontal direction after the etching species atmosphere 85 has been generated. This allows the etching species to have kinetic energy in the horizontal direction relative to the surface of the silicon substrate. As a result, the etching species collide with the sidewalls of the semiconductor layers 11 that extend in the direction normal to the surface of the silicon substrate on the silicon substrate 10. This collision makes it possible to carry out anisotropic etching on the semiconductor layers in the horizontal direction relative to the surface of the silicon substrate.

Here, the etching species may additionally be transferred into the vicinity of the surface of the silicon substrate in the direction normal to the surface of the silicon substrate, after the electric field E has been applied for a certain period of time t1 in the horizontal direction relative to the surface of the silicon substrate, and then, this application of the electric field E is stopped. In addition, the etching species may be transferred into the vicinity of the surface of the silicon substrate while the above described electric field E is applied.

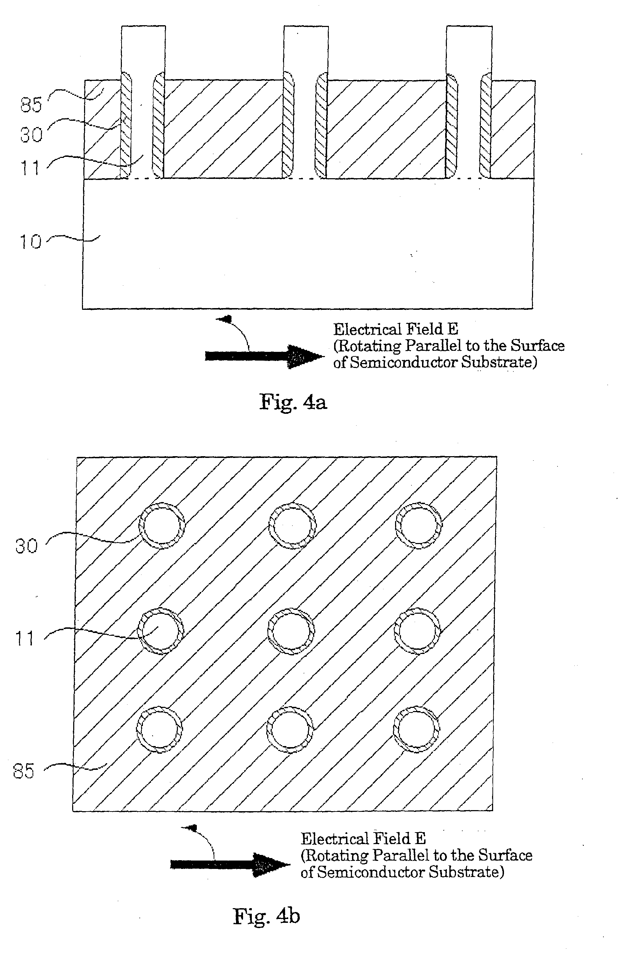

In addition, as shown in Figs. 4a and 4b, the electric field E may be rotated in a plane horizontal to the surface of the silicon substrate and thereby, anisotropic etching may be carried out on the entire periphery of the sidewalls of the semiconductor layers 11 that extend in the direction normal to the surface of the silicon substrate.

Here, it is desirable for the speed at which the electric field E is rotated, in the plane horizontal to the surface of the silicon substrate, to range from 1 to 1000 rotations per minute. However, the speed is not limited to a specific range as long as it is possible to carry out etching in a desired manner.

Here, Fig. 4a is a cross sectional view showing an etching method according to one embodiment of the present invention. Fig. 4b is a plan view of Fig. 4a as seen from above.

In addition, it is desirable for the electric field E that is applied in the horizontal direction relative to the surface of the silicon substrate to be parallel to the surface of the silicon substrate. However, it is not necessary for the direction to be parallel as long as it is possible to carry out anisotropic etching on the sidewalls of semiconductor layers 11, which extend in the direction normal to the surface of the silicon substrate on silicon substrate 10, in the direction horizontal to the surface of the silicon substrate.

In addition, in the case where the etched material is silicon, Cl₂, HBr, CHF₃, or a mixed gas thereof can be used as the above described etching species 80. In the case where the etched material is a silicon oxide film, CF₄, C₅F₈, or a mixed gas thereof can be used as the above described etching species 80. In addition, in the case where the etched material is a silicon nitride film, CHF₃, C₄F₈, or a mixed gas thereof can be used as the above described etching species 80. The types of etched material and etching species are not particularly limited as long as etching is possible in the desired manner.

In addition, the etching method according to the present embodiment is not limited to etching for the semiconductor device using a silicon substrate, the etching method can be applied to semiconductors such as germanium, gallium arsenide, indium phosphide or the like.

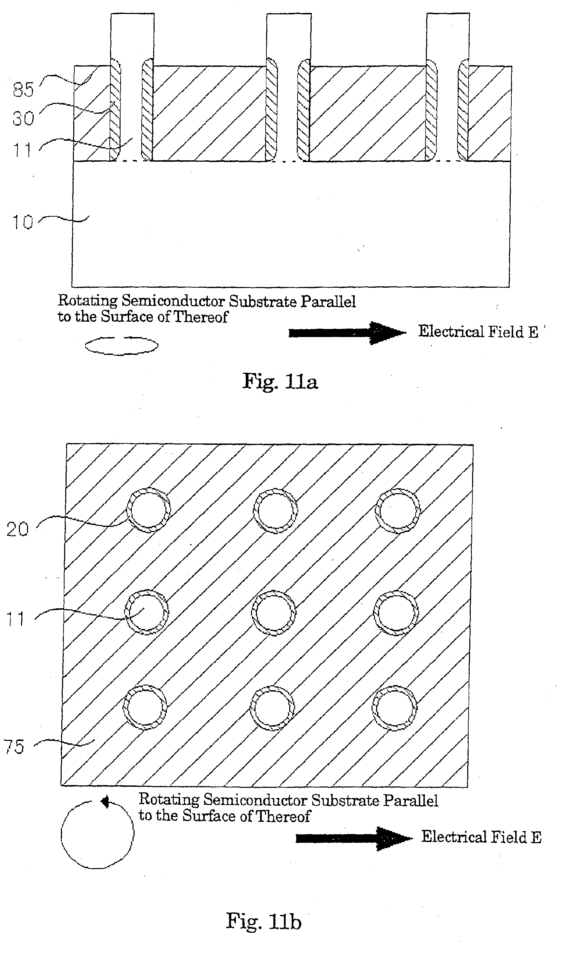

In addition, though the electric field E is rotated in the present embodiment, the silicon substrate 10 may be rotated instead as long as it is possible to carry out etching in a desired manner as shown in Figs. 11a and 11b. Furthermore, the direction of rotation may be either clockwise or anticlockwise.

Here, Fig. 11a is a cross sectional view showing an etching method according to one embodiment of the present invention. Fig. 11b is a plan view of Fig. 11a as seen from above.

### Embodiment 3

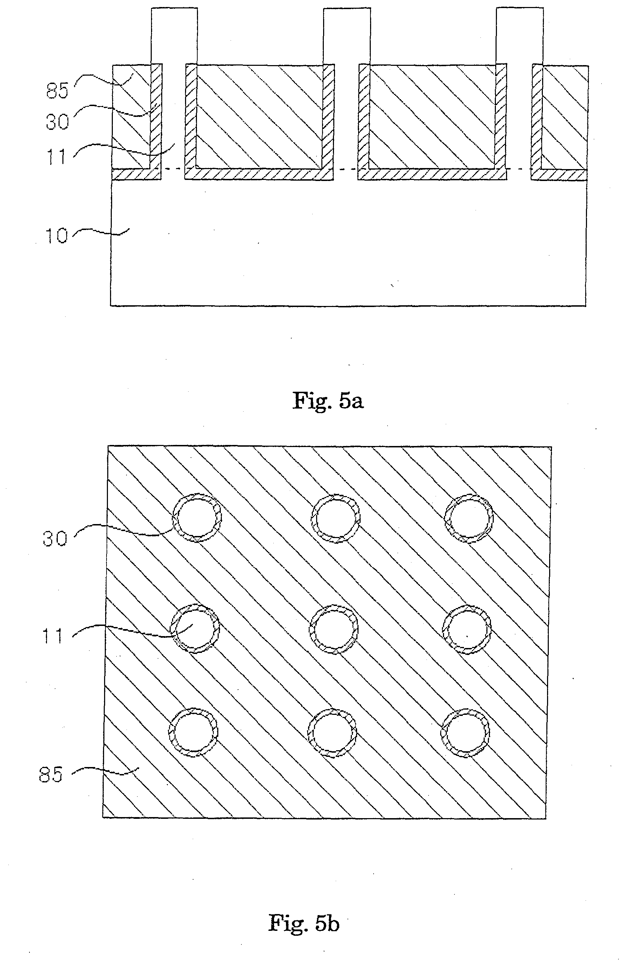

Figs. 5a and 5b are schematic views showing an etching method according to one embodiment of the present invention. Fig. 5a is a cross sectional view and Fig. 5b is a plan view of Fig. 5a as seen from above. Here, though the present embodiment shows a case of a P-type semiconductor substrate, the present invention can also be applied in cases when an N-type semiconductor substrate is used.

In the present embodiment, a P-type silicon substrate 10, for example, is utilized as the P-type semiconductor substrate. In addition, the etching method according to the present invention is applied to the semiconductor device in which semiconductor layers 11 having steps are formed on the silicon substrate 10. An etching species atmosphere 85 is generated when the etching species, for example, ions that have been converted to plasma are transported into the vicinity of the surface of the silicon substrate 10 by means of an electric field of approximately 0.1 V to 1 kV, in the direction normal to the surface of the silicon substrate. Here, the temperature at the time when the etching species atmosphere is generated is set at a level where no chemical reactions occur between the etching species and the processed body, and no etching progresses (for example, room temperature).

Subsequently, the temperature of the etching species atmosphere 85 is raised to a high level, for example, 200°C to 700°C, and thereby, the etching species and the etched body in the vicinity of the surface of the silicon substrate occurs a chemical reaction. As a result, the etching progresses and it becomes possible for isotropic etching to be carried out only on the bottoms of recesses 12 in the silicon substrate. Here, at this time, anisotropic etching may be carried out by utilizing the difference in selective ratio between the bottoms and the sidewalls of the recesses 12 in the silicon substrate.

In addition, the etching method according to the present embodiment is not limited to the etching carried out on the semiconductor device using a silicon substrate, the etching method can be applied to semiconductors such as germanium, gallium arsenide, and indium phosphide.

### Embodiment 4

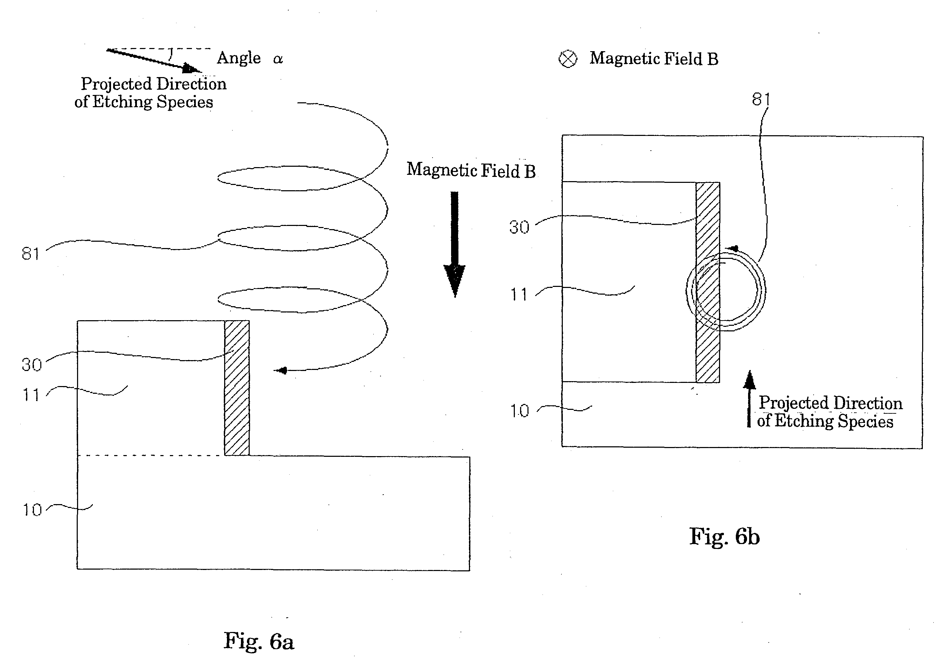

Figs. 6a and 6b are schematic diagrams showing an etching method according to one embodiment of the present invention. Fig. 6a is a cross sectional view and Fig. 6b is a plan view of Fig. 6a as seen from above. Here, though the present embodiment shows a case of a P-type semiconductor substrate, the present invention can be applied to cases where an N-type semiconductor substrate is used.

In the present embodiment, a P-type silicon substrate 10, for example, is utilized as the P-type semiconductor substrate. In addition, the etching method according to the present invention is applied to a semiconductor device in which a semiconductor layer 11 having a step is formed on the silicon substrate 10. Etching species 81 that are accelerated by an electric field of 0.1 V to 1 MV, for example, ions that have been converted into plasma are projected in the direction inclined by 1° to 50° relative to the surface of the silicon substrate. These etching species move in a spiral in a plane that is horizontal to the surface of the silicon substrate by applying a magnetic field B having a magnetic flux density of 1 nT to 100 T in the direction perpendicular to the surface of the silicon substrate. That is to say, the etching species reach the sidewall of the semiconductor layer 11 while moving in a spiral relative to the surface of the silicon substrate.

Here, it is desirable for the magnetic flux density of magnetic field B, that is applied in the direction horizontal to the surface of the silicon substrate, to range from 1 nT to 100 T. However, it is not particularly limited as long as it is possible to carry out etching in a desired manner.

According to the above described technique, the etching species 81 has kinetic energy in the direction horizontal to the surface of the silicon substrate, and the etching species 81 collide with the sidewall of the semiconductor layer 11 that extends from the silicon substrate 10 in the direction normal to the surface of the silicon substrate. This collision makes it possible to carry out anisotropic etching in the direction horizontal to the surface of the silicon substrate.

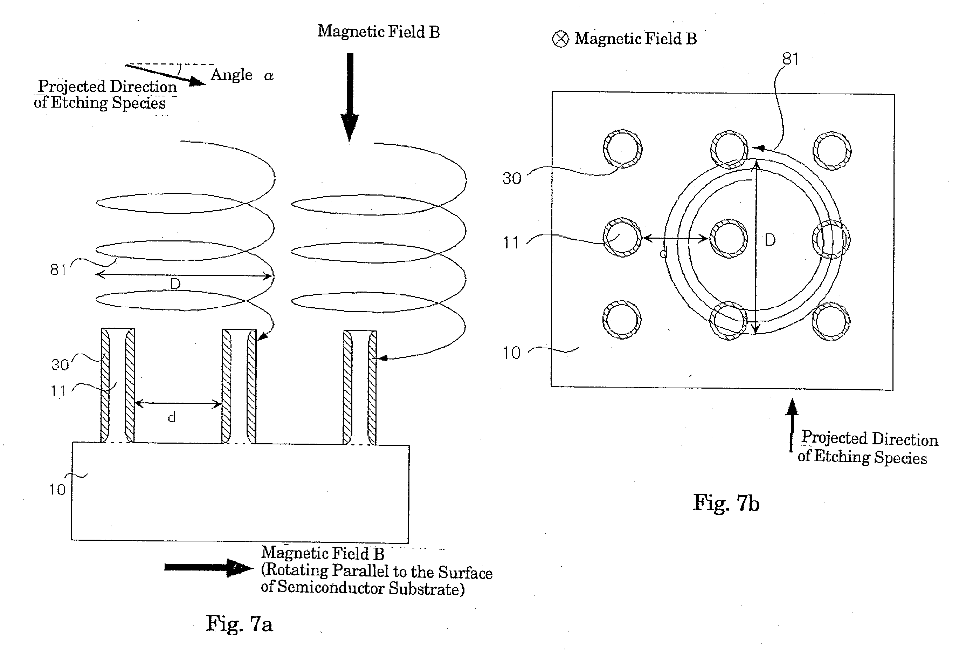

Furthermore, Figs. 7a and 7b show an example in which the etching method is applied to the semiconductor device having at least two or more semiconductor layers 11, which extend in the direction normal to the surface of the silicon substrate, on the silicon substrate 10. In this example a magnetic field B is controlled so as to maintain the relationship of d < D, where d indicates the distance between the above described semiconductor layers 11, and D indicates the diameter of spiral motion of the etching species. As a result, the probability of the etching species, that have reached the surface of the silicon substrate 10 colliding with the sidewalls of the semiconductor layers 11 that extend in the direction normal to the surface of the silicon substrate, is increased. Accordingly, it becomes possible to carry out anisotropic etching more efficiently in the direction horizontal to the surface of the silicon substrate.

Though it is preferable for both the distance d between the semiconductor layers 11 and the diameter D of the spiral motion to be in the range from 1 nm to 10 µm, they are not necessarily limited to this range.

Here, it is desirable for the magnetic field B that is applied in the direction horizontal to the surface of the silicon substrate to be perpendicular to the surface of the silicon substrate. However, it is not necessary for the direction to be perpendicular as long as it is possible to carry out anisotropic etching, in the direction horizontal to the surface of the silicon substrate, on the sidewalls of the semiconductor layers 11 that extend in the direction normal to the surface of the semiconductor substrate.

In addition, in the case where the etched material is silicon, Cl₂, HBr, CHF3, or a mixed gas thereof can be used as the above described etching species 81. In the case where the etched material is a silicon oxide film, CF₄, C₅F₈, or a mixed gas thereof can be used as the above described etching species 81. In addition, in the case where the etched material is a silicon nitride film, CHF₃, C₄F₈, or a mixed gas thereof can be used as the above described etching species 81. The types of the etched material and the etching species are not particularly limited as long as etching is possible in the desired manner.

In addition, the etching method according to the present embodiment is not limited to etching for the semiconductor device using a silicon substrate, and the etching method can be applied to semiconductors such as germanium, gallium arsenide, and indium phosphide.

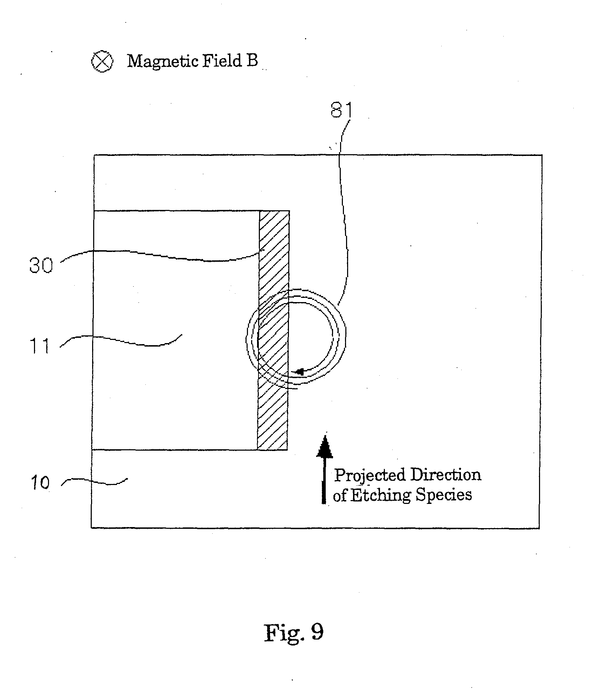

In addition, Fig. 6b and Fig. 7b show a case where the diameter D of the spiral motion of the etching species becomes greater as the etching species approach the silicon substrate 10. However, the present invention is not limited to this, the above described diameter D may become smaller as the etching species approach the silicon substrate 10, as shown in Fig. 9, for example, or may not be changed. That is to say, a change in diameter D is not particularly limited before the etching species reach the silicon substrate and after the etching species have been projected as long as it is possible to carry out etching in a desired manner.

As described above, according to the etching method of the present invention, it is possible to carry out anisotropic etching in the direction horizontal to the surface of the semiconductor substrate.

In addition, it is possible to extend or stack transistors and memory cells in the direction normal to the surface of a semiconductor substrate which had previously been difficult to achieve. Particularly, in the case where the present invention is applied to memory cells which are regularly arranged, it is possible to integrate memory cells with an extremely high packing density, and to realize a semiconductor memory device having a large capacity with a small semiconductor chip area.

## Claims

1. An etching method for a semiconductor device comprising:
generating an etching species atmosphere above the semiconductor device having a step composed of a main surface and a sidewall; and
applying an electric field to accelerate the etching species in one direction and a magnetic field along a plane that crosses the one direction at a specific angle so that the sidewall is etched.

2. An etching method as set forth in claim 1, wherein the magnetic field is rotated along a plane crossing an application direction of the electric field at a specific angle, whereby the etching species move spirally along the application direction of the electric field.

3. An etching method as set forth in claim 1, wherein the electric field is applied perpendicularly to the main surface of the step, and the magnetic field is applied along the main surface of the step.

4. An etching method as set forth in claim 1, wherein the semiconductor device has a plurality of steps formed of a plurality of projections, and the magnetic field is applied so that the etching species move spirally with a diameter of the spiral greater than a distance between adjacent projections.

5. An etching method for a semiconductor device comprising the steps of:
generating an etching species atmosphere above the semiconductor device having a step composed of a main surface and a sidewall; and
applying an electric field along a plane that crosses the main surface at a specific angle so that the etching species are accelerated to etch the sidewall.

6. An etching method as set forth in claim 5, wherein the electric field is applied while being rotated parallel to the main surface of the step.

7. An etching method as set forth in claim 5, wherein the semiconductor device has a plurality of steps formed of a plurality of projections.

8. An etching method for a semiconductor device comprising the steps of:
generating an etching species atmosphere above the semiconductor device having a step composed of a main surface and a sidewall; and
heating the etching species and a material forming the sidewall to a predetermined temperature at which the etching species and the material react with each other to etch the sidewall.
